# EUROPEAN PATENT APPLICATION

(11) **EP 2 528 423 A1**
(43) Date of publication of application: **28.11.2012**
(21) Application number: 12155740.9
(22) Date of filing: 16.02.2012
(51) Int. Cl.: H05K 7/20

(54) **Heat-dissipation device and electronic device thereon**

(30) Priority: 25.05.2011 TW 100118233
(71) Applicant: Giga-Byte Technology Co., Ltd., New Taipei City 231 (TW)
(72) Inventor: Kao, Han Yu, 231 New Taipei City (TW); Liao, Tse Hsine, 231 New Taipei City (TW); Kuei, Min Chen, 231 New Taipei City (TW)
(74) Representative: Schwerbrock, Florian

(57) **Abstract**

A heat dissipation device is used for a circuit board, and plural electronic components are mounted on a surface of the circuit board. The heat dissipation device includes a heat dissipation plate that is made of metal. Once the heat dissipation plate shields above a surface of the circuit board, a distance exists between the heat dissipation plate and the surface so as to form an air flow passage to increase the heat dissipation performance.

## Description

### BACKGROUND OF THE INVENTION

### Field of Invention

The present invention relates to a heat-dissipation device. More particularly, the present invention relates to a heat-dissipation device, which includes a heat dissipation plate disposed above a circuit board.

### Related Art

Due to the fast operating speed of electronic components of computer devices, and the substantially miniaturized volume of electronic devices, the heat dissipation per unit volume of the computer devices is therefore increased. If the heat is not promptly removed, the excessively high temperature will deteriorate the stability and the efficiency of the electronic components seriously, even shortens the life of the computer devices, or damages the computer devices.

At present, the heat dissipation of the printed circuit boards of electronic devices mostly uses a fan module to dissipate heat, for example, the electronic components such as central process unit (CPU), south bridge chip and so on, which are electrically disposed on the printed circuit board dissipating substantial heat during the operation, which demands the fan to convert heat dissipation. However, when an electronic device operates for a long time, the heat generated from the printed circuit board will substantially increase; the effect of heat dissipation can not be achieved only relying on the fan module within the electronic device, which causes the electronic devices unable to operate normally and effectively.

The prior heat dissipation by a fan module only dissipates heat at specific regions of the printed circuit board while the regions of the printed circuit board without the mounting of the fan module can not remove the heat promptly under a long operating time; therefore, the working temperature within the computer devices is not uniform, so that the overall heat-dissipating performance can not be increased, which easily drives the electronic components into short-circuit or over-burning.

### SUMMARY OF THE INVENTION

In view of the above problems, the present invention provides a heat-dissipation device and an electronic device, to solve the problems existing in the prior art, which only use a fan module to dissipate heat that causes the electronic device to have unequal heat dissipation.

A heat-dissipation device of the present invention is used for a circuit board, the circuit board has a first surface and a second surface opposite to the first surface, and plural electronic components are mounted on the first surface of the circuit board. The heat-dissipation device includes a first heat dissipation plate made of metal and being shielded above the first surface of the circuit board, where a distance is formed between the first heat dissipation plate and the first surface of the circuit board, which constitutes an air flow passage.

The heat-dissipation device of the present invention further includes a second heat dissipation plate made of metal and being shielded above the second surface of the circuit board, where a distance is formed between the second heat dissipation plate and the second surface of the circuit board. Moreover, the electronic device has a shell, where the second heat dissipation plate attaches to the shell one with the other.

The electronic device of the present invention includes a circuit board and a heat-dissipation device. The circuit board has a first surface and a second surface opposite to the first surface, and the heat-dissipation device has a first heat dissipation plate and a second heat dissipation plate that are made of metal. The first heat dissipation plate is shielded above the first surface of the circuit board while the second heat dissipating plate is shielded above the second surface of the circuit board, and a distance is formed between the first heat dissipation plate and the first surface, and between the second heat dissipation plate and the second surface respectively to constitute an air flow passage each.

In comparison with the prior art, heat-dissipation device of the present invention uses the heat dissipation plate to dissipate heat from the circuit board of an electronic device, and heat generated from the electronic components of the circuit board is removed through the air flow passage by means of air convection. Moreover, the heat of the electronic components dissipates through metal dissipation plate by means of heat conduction. Heat dissipation by convection and conduction at the same time would obtain superior performance.

The technical characteristics, realization and features of the present invention will become apparent with the detailed description of preferred embodiments and related drawings as follows.

### BRIEF DESCRIPTION OF THE DRAWINGS

Figure 1 illustrates an exploded perspective diagram of a first embodiment of the present invention ;
Figure 2A illustrates a three-dimensional schematic diagram of the first embodiment of the present invention ;
Figure 2B illustrates a schematic diagram of locking to the shell of the first embodiment of the present invention ;
Figure 3 illustrates a cross-sectional view taken along the line A-A' of FIG. 2A ;
Figure 4 illustrates a cross-sectional view of another combining manner of the first embodiment of the present invention ;
Figure 5 illustrates an exploded perspective diagram of a second embodiment of the present invention ;
Figure 6A illustrates a three-dimensional schematic diagram of the second embodiment of the present invention ;
Figure 6B illustrates a schematic diagram of locking to the shell of the second embodiment of the present invention ;
Figure 7 illustrates a cross-sectional view taken along the line B-B' of FIG. 6A ; and
Figure 8 illustrates a cross-sectional view of another combining manner of the second embodiment of the present invention.

### DETAIL DESCRIPTION OF THE INVENTION

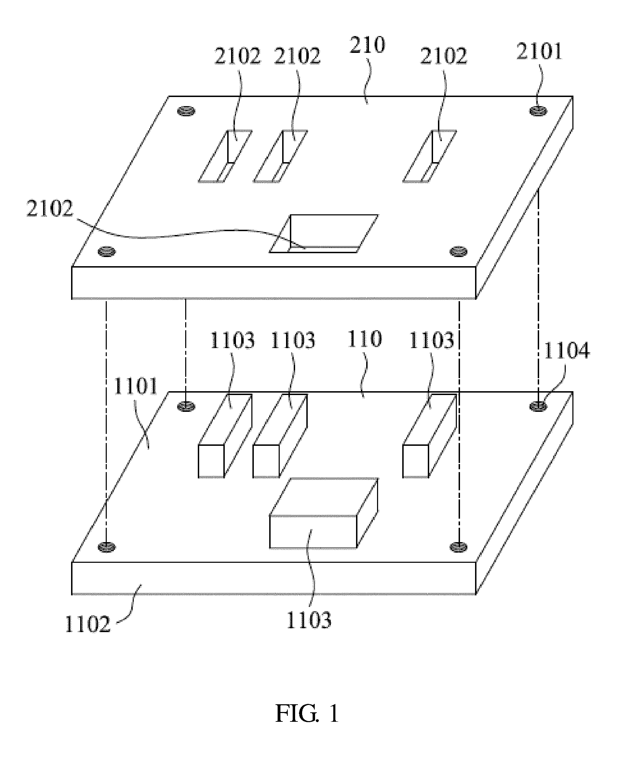

FIGS. 1 to 4 are diagrams of a heat-dissipation plate 210 of the first embodiment of the present invention that is shielded on a circuit board 110. Please refer to FIG. 1 that illustrates a three-dimensional exploded diagram of the first embodiment, the heat-dissipation device 100 of the first embodiment includes a first heat dissipation plate 210 suitable for a circuit board 110, where the circuit board 110 has a first surface 1101 and a second surface 1102 opposite to the first surface 1101, and the first surface 1101 of the circuit board 110 is electrically provided with plural electronic components 1103. Moreover, the circuit board 110 further has plural combining holes 1104.

The first heat dissipation plate 210 has plural openings 2102, which correspond to the plural electronic components 1103 of the circuit board 110, and the first heat dissipation plate 210 further has plural fixed holes 2101. The first heat dissipation plate 210 disclosed in the first embodiment is made of metal which is provided with high thermal conductivity, such as copper, copper alloy, aluminum, aluminum alloy and so on. However, the purpose of the first heat dissipation plate 210 is to achieve heat conduction and heat dissipation, thus the material of the first heat dissipation plate 210 of the present invention is not limited.

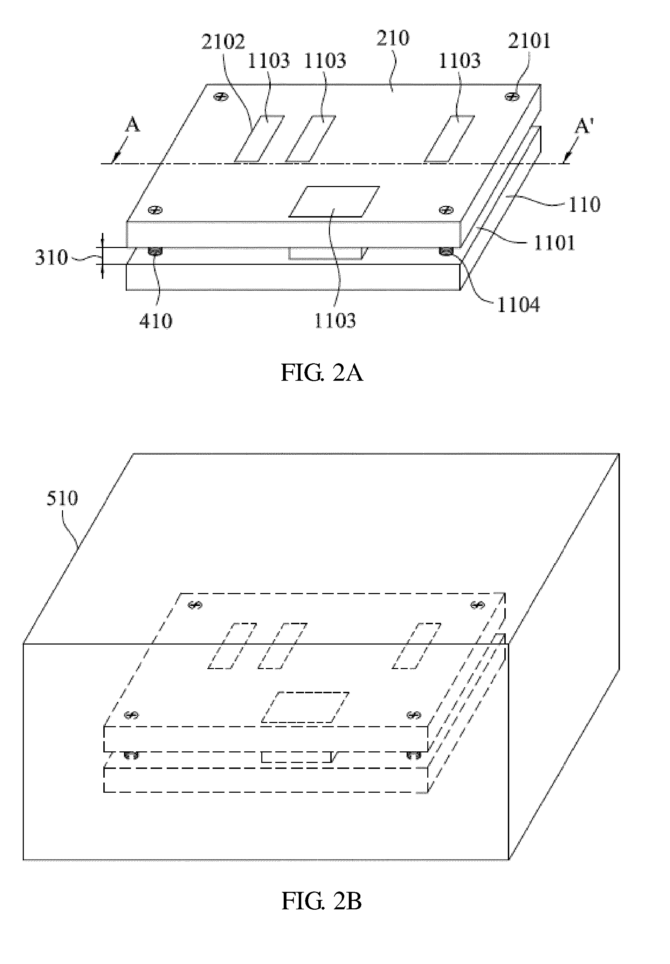

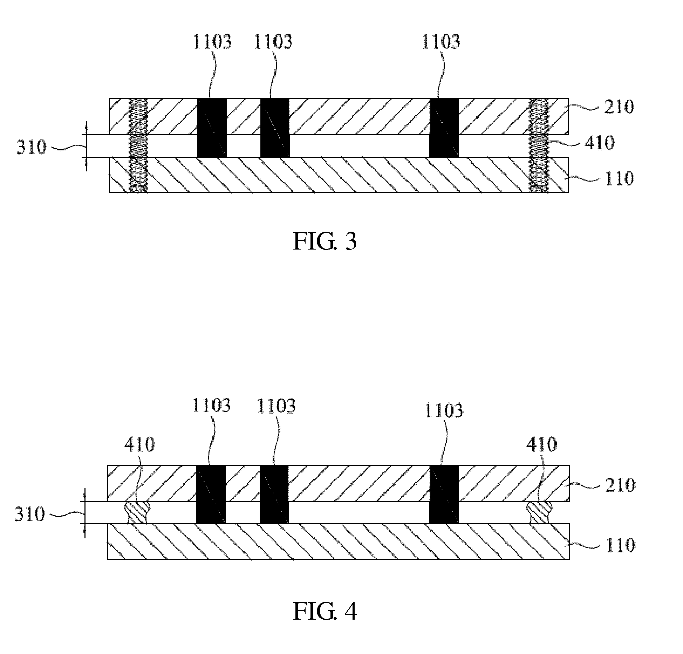

Please refer to FIG. 2A and FIG. 2B that illustrate three-dimensional schematic diagrams of the first embodiment. While the first heat dissipation plate 210 shields above the first surface 1101 of the circuit board 110, the electronic components 1103 electrically disposed on the first surface 1101 of the circuit board 110 accommodate within the openings 2102 of the first heat dissipation plate 210 respectively, and the plural fasteners 410 pass through the fixed holes 2101 of the first heat dissipation plate 210 respectively and are fixed in the combining holes 1104 of the circuit board 110, so that the first heat dissipation plate 210 shields above the first surface 1101 of the circuit board 110. Thus, a distance 310 forms between the first heat dissipation plate 210 and the first surface 1101 of the circuit board 110, to constitute an air flow passage. Please refer to FIG. 2B, the fasteners 410 are further to be used to lock to a shell 510, which causes the first surface 1101 of the circuit board 110 to achieve superior performance of heat dissipation by the first heat dissipation plate 210 while the second surface 1102 of the circuit board 110 to achieve the same purpose by the shell 510. As shown along the line A-A' of FIG. 2A, the combining manner of the circuit board 110 and the first heat dissipation plate 210 and the heat dissipation generated by the above two are accordingly described. Meanwhile, referring to FIGS. 3 and 4, the cross-sectional view taken along the line A-A' of FIG. 2A of the first embodiment is illustrated.

As shown in FIG. 3, while the first heat dissipation plate 210 shields above the first surface 1101 of the circuit board 110, the electronic components 1103 of the circuit board 110 pass through the first heat dissipation plate 210, and the fasteners 410 also pass through the first heat dissipation plate 210, which are fixed in the circuit board 110. The fastener 410 can be screw, bolt and so on, which can able to fix the circuit board 110 and the first heat dissipation plate 210 each other, the scope of the present invention is not limited the combining manner that disclosed in the embodiment.

Please refer to FIG. 4 that illustrates the cross-sectional view of another combining manner of the first embodiment. While the first heat dissipation plate 210 shields above the first surface 1101 of the circuit board 110, the electronic components 1103 of the circuit board 110 pass through the first heat dissipation plate 210, and the first heat dissipation plate 210 adheres to the first surface 1101 of the circuit board 110 by an adhesive agent, that is, the adhesive agent disposes between the first heat dissipation plate 210 and the first surface 1101 of the circuit board 110, where the first heat dissipation plate 210 suspends above the circuit board 110, so that the distance 310 exists between the first heat dissipation plate 210 and the circuit board 110, so as to form the air flow passage.

What is noteworthy that, the combining manner of the first heat dissipation plate 210 disclosed in the present invention is not limited in the above-mentioned embodiment, a person skilled in the art could depend on his needs to adopt any suitable combining manner.

While the electronic components 1103 of the circuit board 110 operates, heat produced from the electronic components 1103 passes through the distance 310 and conducts to the first heat dissipation plate 210 by means of air convection and heat conduction, so as to achieve heat dissipation effect. While heat produced from the circuit board 110 by way of convection manner, where the hot air flows upward and the cold air flows downward, so that a heat circulation is constituted. When the first heat dissipation plate 210 not contact with the heat source, the first heat dissipation plate 210 has low temperature condition, where hot air contacts with the first heat dissipation plate 210, heat conducts to the first heat dissipation plate 210 and dissipates by cold air, so as to achieve heat dissipation effect. Hence, the stability of the electronic device is able to increasing, and the life of the electronic components 1103 is able to lengthening.

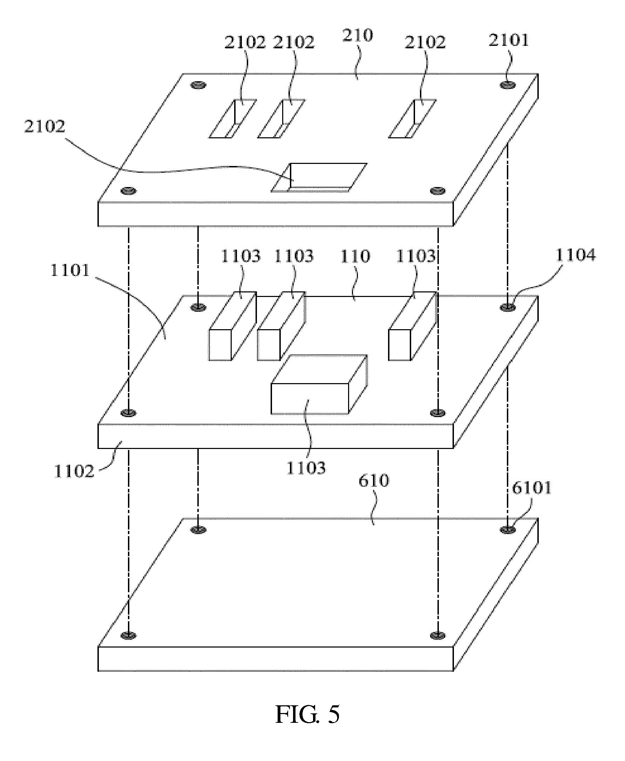

FIG. 5 to FIG. 8 are diagrams of a heat-dissipation device of the second embodiment of the present invention. Please refer to FIG. 5 that illustrates an exploded perspective diagram of the second embodiment, the heat-dissipation device 100 of the second embodiment includes a first heat dissipation plate 210 and a second heat dissipation plate 610 which utilized to dissipate a circuit board 110. The circuit board 110 has a first surface 1101 and a second surface 1102 which is opposite to the first surface 1101, and plural electronic components 1103 electrically mounted on the first surface 1101 of the circuit board 110. Moreover, the circuit board 110 further has plural combining holes 1104.

The first heat dissipation plate 210 has plural openings 2102, which correspond to the electronic components 1103 of the circuit board 110, and the first heat dissipation plate 210 further has plural first fixed holes 2101, and the second heat dissipation plate 610 further has plural second fixed holes 6101. The first heat dissipation plate 210 and the second heat dissipation plate 610 disclosed in the second embodiment are made of metal which provided with high thermal conductivity coefficient, for example, the metal such as copper, copper alloy, aluminum, aluminum alloy and so on. However, the purpose of the first heat dissipation plate 210 and the second heat dissipation plate 610 is to achieve heat conduction and heat dissipation, thus the scope of the present invention is not limited material of the first heat dissipation plate 210 and the second heat dissipation plate 610 that disclosed in the embodiment.

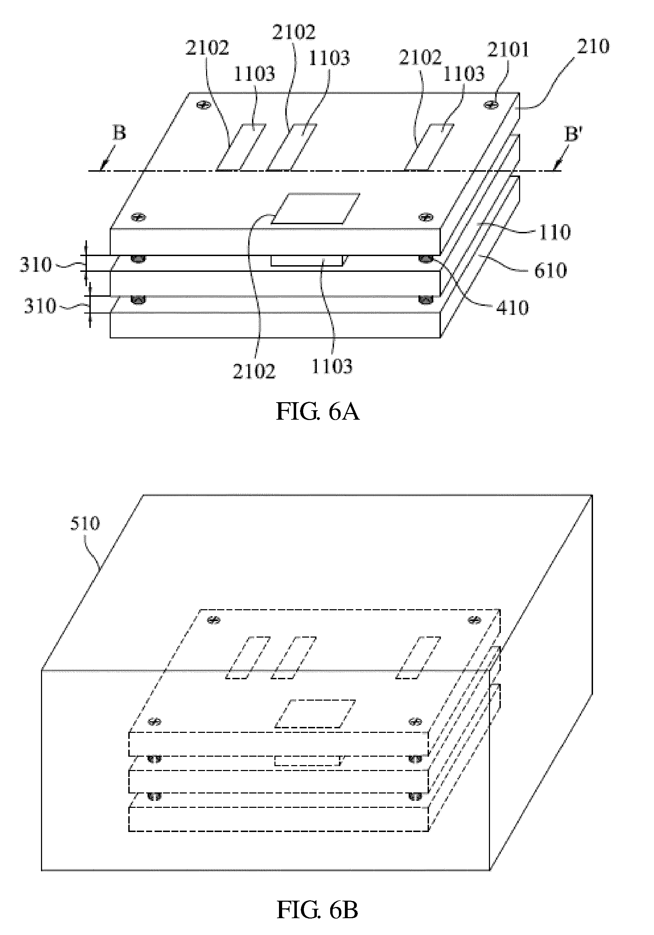

Please refer to FIG. 6A and FIG. 6B that illustrate schematic diagrams of the second embodiment, while the first heat dissipation plate 210 shields above the first surface 1101 of the circuit board 110, the electronic components 1103 electrically disposed on the first surface 1101 of the circuit board 110 where accommodate within the openings 2102 of the first heat dissipation plate 210 respectively. Furthermore, plural fasteners 410 pass through the fixed holes 2101 of the first heat dissipation plate 210 respectively, and the fasteners 410 are fixed in the combining holes 1104 of the circuit board 110, so that the first heat dissipation plate 210 suspends above the first surface 1101 of the circuit board 110. Thus, a distance 310 forms between the first heat dissipation plate 210 and the first surface 1101 of the circuit board 110, so as to constitute an air flow passage. Moreover, while the second heat dissipation plate 610 shields above the second surface 1102 of the circuit board 110, the fasteners 410 pass through the second fixed holes 6101 of the second heat dissipation plate 610 respectively, so that the second heat dissipation plate 610 suspends above the second surface 1102 of the circuit board 110. Thus, another distance 310 forms between the second heat dissipation plate 610 and the second surface 1102 of the circuit board 110, so as to constitute another air flow passage. Please refer to FIG. 6B, the fasteners 410 further lock on a shell 510, that cause the first surface 1101 of the circuit board 110 achieve superior performance by the first heat dissipation plate 210, and the second surface 1102 of the circuit board 110 achieve superior performance by the second heat dissipation plate 610.

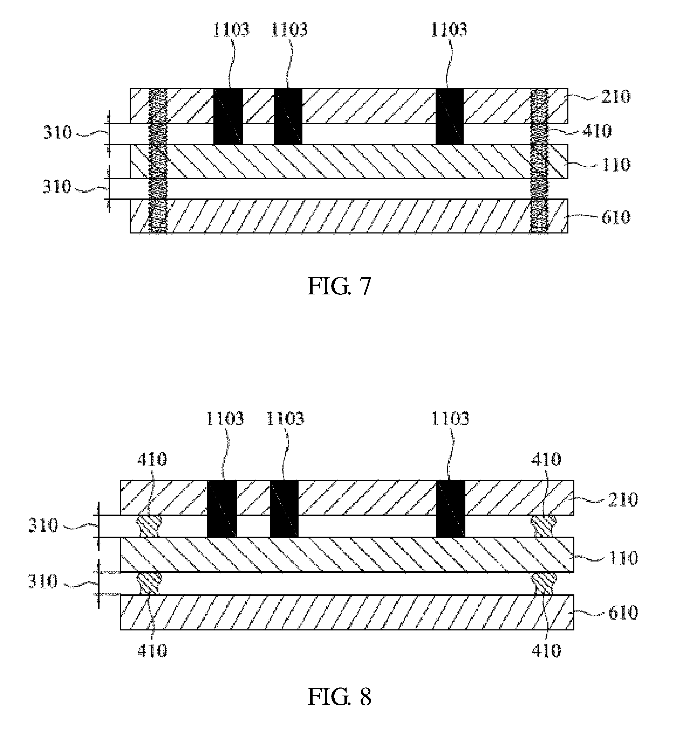

As shown in FIG. 7 that is to explain the combining manner and the heat dissipation performance of the circuit board 110, the first heat dissipation plate 210, and the second heat dissipation plate 610. And, please refer to FIG. 7 and FIG. 8 that illustrates cross-sectional views taken along the line B-B' of FIG. 6A of the second embodiment.

Please refer to FIG. 7, while the first heat dissipation plate 210 shields above the first surface 1101 of the circuit board 110, the electronic components 1103 pass through the first heat dissipation plate 210, and the fasteners 410 also pass through the first heat dissipation plate 210 and the circuit board 110, which are fixed in the second heat dissipation plate 610. The fastener 410 can be screw, bolt and so on, which can able to fix the circuit board 110, the first heat dissipation plate 210, and the second heat dissipation plate 610 each other, the scope of the present invention is not limited the combining manner that disclosed in the embodiment.

Please refer to FIG. 8 that illustrates the cross-sectional view of another combining manner of the second embodiment. While the first heat dissipation plate 210 shields above the first surface 1101 of the circuit board 110, the electronic components 1103 of the circuit board 110 pass through the first heat dissipation plate 210, and the first heat dissipation plate 210 adheres to the first surface 1101 of the circuit board 110 by an adhesive agent, that is, the adhesive agent disposes between the first heat dissipation plate 210 and the first surface 1101 of the circuit board 110, where the first heat dissipation plate 210 suspends above the circuit board 110, so that the distance 310 exists between the first heat dissipation plate 210 and the circuit board 110, and then, the second heat dissipation plate 610 adheres to the second surface 1102 of the circuit board 110 by another adhesive agent, that is, the adhesive agent disposes between the second heat dissipation plate 610 and the second surface 1102 of the circuit board 110, where the second heat dissipation plate 610 suspends above the circuit board 110, so that another distance 310 exists between the second heat dissipation plate 610 and the circuit board 110. The above-mentioned distances form the air flow passages.

What is noteworthy that, the combining manner of the first heat dissipation plate 210 and the second heat dissipation plate 610 disclosed in the present invention is not limited in the above-mentioned embodiment, a person skilled in the art could depend on his needs to adopt any suitable combining manner.

While the electronic components 1103 of the circuit board 110 operates, heat produced from the electronic components 1103 passes through the distance 310 and conducts to the first heat dissipation plate 210 and the second heat dissipation plate 610 by means of air convection and heat conduction, so as to achieve heat dissipation effect. While heat produced from the circuit board 110 by way of convection manner, where the hot air flows upward and the cold air flows downward, so that a heat circulation is constituted.

When the first heat dissipation plate 210 and the second heat dissipation plate 610 not contact with the heat source, the first heat dissipation plate 210 and the second heat dissipation plate 610 have low temperature condition, where hot air contacts with the first heat dissipation plate 210 and the second heat dissipation plate 610, heat conducts to the first heat dissipation plate 210 and the second heat dissipation plate 610, so as to dissipate by cold air; meanwhile, heat also passes through the second heat dissipation plate 610 to conducts to the shell 510, where the circuit board 110 can be cooling uniformly and effectively, so as to achieve heat dissipation effect. Hence, the stability of the electronic device is able to increasing, and the life of the electronic components 1103 is able to lengthening.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A heat-dissipation device being used for a circuit board (110), the circuit board (110) having a first surface (1101) and a second surface (1102) opposite to the first surface (1101), and a plurality of electronic components (1103) mounted on the first surface (1101) of the circuit board (110); the heat-dissipation device **characterized by** comprising a first heat dissipation plate (210) made of metal and shielded above the first surface (1101), wherein a distance (310) is formed between the first heat dissipation plate (210) and the first surface (1101) of the circuit board (110) and an air flow passage is constituted.

2. A heat-dissipation device as in claim 1, wherein the first heat dissipation plate (210) further comprises a plurality of openings (2102), which correspond to the electronic components (1103), the electronic components (1103) accommodated within the openings (2102) respectively while the first heat dissipation plate (210) shields above the first surface (1101).

3. A heat-dissipation device as in claim 1, wherein the first heat dissipation plate (210) further comprises a plurality of fixed holes (2101), and the circuit board comprises a plurality of combining holes (1104), a plurality of fasteners (410) passing through the fixed holes (2101) respectively, and the fasteners (410) being fixed in the combining holes (1104), so that the first heat dissipation plate (210) suspends above the first surface (1101).

4. A heat-dissipation device as in claim 1, further comprising an adhesive agent, which adheres between the first heat dissipation plate (210) and the first surface (1101) of the circuit board (110), so that the first heat dissipation plate (210) suspends above the first surface (1101).

5. A heat-dissipation device as in claim 1, wherein the first heat dissipation plate (210) is made by copper, copper alloy, aluminum, or aluminum alloy.

6. A heat-dissipation device as in claim 1, further comprising a second heat dissipation plate (610), which is made of metal, the second heat dissipation plate (610) shielding above the second surface (1102) of the circuit board (110), an air flow passage being formed between the second heat dissipation plate (610) and the second surface (1102), and the electronic device having a shell (510), the second heat dissipation plate (610) attaching to the shell (510).

7. A heat-dissipation device as in claim 6, wherein the second heat dissipation plate (610) is made by copper, copper alloy, aluminum, or aluminum alloy.

8. A heat-dissipation device as in claim 6, wherein the first heat dissipation plate (210) further comprises a plurality of first fixed holes (2102), the second heat dissipation plate (610) further comprises a plurality of second fixed holes (6101), and the circuit board (110) comprises a plurality of combining holes (1104), a plurality of fasteners (410) passing through the first fixed holes (2102) and the combining holes (1104) respectively, and the fasteners (410) being fixed in the second fixed holes (6101), so that the first heat dissipation plate (210) suspends above the first surface (1101), and the second heat dissipation plate (610) suspends above the second surface (1102).

9. A heat-dissipation device as in claim 6, further comprising an adhesive agent, which adheres to the first heat dissipation plate (210), the second heat dissipation plate (610) and the circuit board (110), and the adhesive agent adhering between the first surface (1101) of the circuit board (110) and the first heat dissipation plate (210), so that the first heat dissipation plate (210) suspends above the first surface (1101), and the adhesive agent adhering between the second surface (1102) of the circuit board (110) and the second heat dissipation plate (610), where the second heat dissipation plate (610) suspends above the second surface (1102).

10. An electronic device, **characterized by** comprising:
a circuit board (110), having a first surface (1101) and a second surface (1102) opposite to the first surface (1101); and
a heat-dissipation device, having a first heat dissipation plate (210) and a second heat dissipation plate (610), which are made of metal, the first heat dissipation plate (210) shielding above the first surface (1101), wherein a distance (310) is formed between the first heat dissipation plate (210) and the first surface (1101) of the circuit board (110), which constitutes an air flow passage, and the second heat dissipation plate (610) shielding above the second surface (1102), wherein a distance (310) is formed between the second heat dissipation plate (610) and the second surface (1102) of the circuit board (110), and an air flow passage is constituted.
